# EUROPÄISCHE PATENTSCHRIFT

(11) **EP 0 752 592 B1**
(45) Veröffentlichungstag und Bekanntmachung des Hinweises auf die Patenterteilung: **08.03.2006**
(21) Anmeldenummer: 96110633.3
(22) Anmeldetag: 02.07.1996
(51) Int. Cl.: G01R 31/00, B60R 21/00

(54) **Verfahren und System zum Erkennen von Isolationsfehlern**
Method and system for detecting insulation faults
Procédé et système de détection de défauts d'isolation

(30) Priorität: 06.07.1995 DE 19524615
(43) Veröffentlichungstag der Anmeldung: 08.01.1997
(73) Patentinhaber: Conti Temic microelectronic GmbH, 90411 Nürnberg (DE)
(72) Erfinder: Fendt, Günter, 86529 Schrobenhausen (DE); Hora, Peter, 86529 Schrobenhausen (DE); Spies, Hans, 85276 Pfaffenhofen (DE); Wetzel, Guido, 86633 Neuburg (DE)

(56) Entgegenhaltungen:
- EP-A- 0 641 688
- DE-A- 4 029 703
- DE-A- 4 445 093
- PATENT ABSTRACTS OF JAPAN vol. 018, no. 025 (M-1542), 14.Januar 1994 & JP 05 262202 A (FUJITSU TEN LTD), 12.Oktober 1993,

## Beschreibung

Die Erfindung betrifft ein Verfahren und ein System zum Erkennen von Isolationsfehlern in einer Schaltung, die mit einer niederohmigen Stromquelle oder -senke mit Ruhespannung Uₙ₀ verbunden werden soll.

Unter "Stromquelle" und "Stromsenke" wird hier jeweils ein Einpol verstanden (der zu seiner eigenen Versorgung selbstverständlich weiter Pole haben kann), der Strom liefern bzw. aufnehmen kann. Zum Beispiel ist demnach eine Batterie mit Plus- und Minuspol eine Kombination aus Stromquelle und -senke.

"Niederohmig" bedeutet hier, daß die Stromquelle bzw. -senke im Fall eines Kurzschlusses in der Schaltung einen so großen Strom hervorrufen kann, daß dieser eine nachteilige Wirkung haben kann. Im Gegensatz dazu bleibt der Strom einer hochohmigen oder strombegrenzten Stromquelle bei relativ kleinen Werten, die keine solche Wirkung haben können.

Ein Beispiel für eine solche niederohmige Stromquelle und -senke ist eine Autobatterie, die über Kabel mit elektrischen Verbrauchern verbindbar ist. Liegt in einem Verbraucher, z.B. dem Starter aufgrund eines Isolationsfehlers ein Masseschluß vor, so kann der beim Verbinden mit der Stromquelle (d.h. dem Pluspol der Batterie) fließende hohe Kurzschlußstrom zu einer Erhitzung der Verbindungskabels und damit zu einem Kabelbaumbrand führen.

Ein anderes Beispiel für eine niederohmige Stromquelle und -senke ist die Stromversorgung zum Auslösen der Zündpille eines Airbag-Systems in einem Kraftfahrzeug. Normalerweise ist die Zündpille mit ihren beiden Polen von der Stromversorgung getrennt. Wie unten noch näher erläutert wird, wird sie jedoch bei einer Selbstdiagnose des Airbag-Systems mit einem ihrer Pole mit der niederohmigen Stromquelle (d.h. dem Pluspol der Stromversorgung) verbunden. Hat dann ihr anderer Pol aufgrund eines Isolationsfehlers Masseschluß, wird sie - und damit der Airbag - unerwünscht ausgelöst.

Im einzelnen weist ein Airbag-System im Stand der Technik im allgemeinen zur vollständigen Entkopplung der Zündpille im Normalbetrieb zwei Leistungsschalter auf, von denen einer in dem Strompfad von der niederohmigen Stromquelle (d.h. dem Pluspol der Stromversorgung) zu einem Pol der Zündpille und der andere in demjenigen von dem anderen Pol der Zündpille zur niederohmigen Stromsenke (d.h. zur Masse) liegt. Beim Schließen beider Schalter zündet die Zündpille. Um seine Funktionsfähigkeit sicherzustellen, führt ein solches System laufend Eigendiagnosen durch. Dabei werden alle Komponenten des Systems überprüft, und zwar neben Aufprallsensoren und Zünd- und Autarkiekondensatoren insbesondere die Zündpille und die beiden Leistungschalter. Zur Zündpillenprüfung wird bei geöffneten Leistungsschaltern ein Pol der Zündpille mit einer strombegrenzten Stromquelle und der andere mit einer strombegrenzten Stromsenke gekoppelt. Dadurch fließt ein begrenzter Prüfstrom im Nichtauslösebereich durch die Zündpille. Die Prüfung beruht dann auf einer Auswertung der über sie abfallenden Spannung. Zur Prüfung der Leistungsschalter wird jeweils einer der Schalter geschlossen, so daß ein Prüfstrom in einem Fall von der niederohmigen Stromquelle durch den geschlossenen Schalter und die Zündpille zur strombegrenzten Stromsenke und im anderen Fall von der strombegrenzten Stromquelle durch die Zündpille und den geschlossenen Schalter zur niederohmigen Stromsenke fließt. Der Prüfstrom wird hierbei nur durch die auf der Seite des offenen Schalters liegende strombegrenzte Stromquelle bzw. -senke begrenzt; die auf der Seite des geschlossenen Schalters liegende ist jeweils der niederohmigen Stromquelle bzw. -senke parallel geschaltet und damit wirkungslos. Die Prüfung beruht dann jeweils auf einer Auswertung des durch den Schalter fließenden Stromes, der mit einer Fühlereinrichtung abgegriffen werden kann. Ein Kurzschluß kann hierbei nun - wie oben bereits erwähnt - zu einer Fehlauslösung des Airbags führen: Im ersten oben genannten Fall hebt ein Kurzschluß zur niederohmigen Stromsenke (d.h. ein Masseschluß) die Strombegrenzung durch die Stromsenke auf und läßt - sofern er sich auf der stromabwärtigen Seite der Zündpille befindet - den vollen Zündstrom durch sie fließen, was die Fehlauslösung herbeiführt. Entsprechendes passiert mit allerdings geringerer Häufigkeit, wenn im zweiten oben genannten Fall auf der stromaufwärtigen Seite der Zündpille ein Kurzschluß zur niederohmigen Stromquelle (ein sog. Anliegeschluß gegen die Spannung U der Batterie) vorliegt.

Im Stand der Technik ist es zur Vermeidung solcher Fehlauslösungen bekannt, vor der Schalterprüfung eine Masseschlußprüfung durchzuführen, indem man die Zündpille mit einem so geringfügig über dem Massepotential liegenden Prüfpotential koppelt, daß der Prüfstrom im Masseschlußfall nicht zur Zündung ausreicht. Man mißt die Prüfspannung, schließt, falls sie einen vorgegebenen Wert untersschreitet, auf einen Kurzschluß und führt dann die sonst folgende Schalterprüfung nicht durch. In der Mehrzahl der Fälle kann man dadurch eine Fehlauslösung des Airbags vermeiden. Es verbleibt dennoch eine unakzeptabel große Häufigkeit von Fehlauslösungen bei der Schalterprüfung.

Es wurde erkannt, daß diese verbleibenden Fehlauslösungen in der Regel ebenfalls auf Isolationsfehlern beruhen, die jedoch bei der oben beschriebenen Kurzschlußprüfung mit relativ niedriger Prüfspannung nicht erkannt werden. Es handelt sich hierbei z.B. um Kabelstellen mit durchgescheuerter Isolation, metallische Abriebe oder Späne, vor allem im Zündpillen-Steckerbereich, die zunächst noch keinen Kontakt zur Masse herstellen und sich daher bei der Prüfung mit niedriger Prüfspannung nicht zeigen. Erst beim Anliegen der relativ hohen statischen Spannung bei der folgenden Schalterprüfung kommt aufgrund der dann relativ großen elektrostatischen Anziehungskräfte ein Kontakt zustande. Ein anfänglicher Stromfluß bedingt ein "Zusammenschweißen" an der Kontaktstelle und damit eine weitgehende Verringerung des Übergangswiderstands, so daß es zum Masseschluß mit Airbag-Fehlauslösung kommt.

Der Erfindung liegt das technische Problem zugrunde, derartige Nachteile zu überwinden.

Dieses Problem wird durch ein Verfahren mit den Merkmalen von Anspruch 1 und durch ein System mit den Merkmalen von Anspruch 9 gelöst. Bevorzugte Ausgestaltungen der Erfindung ergeben sich aus den abhängigen Ansprüchen.

Sie löst dieses Problem durch ein Verfahren zum Erkennen von Isolationsfehlern in einer Schaltung, die mit einer niederohmigen Stromquelle oder -senke mit Ruhespannung Uₙ₀ verbunden werden soll, bei welchem
a) die Schaltung in aufgetrenntem Zustand mit einer Prüfspannung aus einer strombegrenzten Stromquelle bzw. -senke, deren Ruhespannung Uₕ₀ der Spannung Uₙ₀ entspricht oder sie überschreitet bzw. - im Fall einer Stromsenke - unterschreitet, beaufschlagt wird (die Indices "n" und "h" stehen hierbei für "niederohmig" bzw. "hochohmig");
b) aus dem Strom- und/oder Spannungs-Verhalten bei der Prüfspannungsbeaufschlagung auf das Vorliegen oder Nichtvorliegen eines lsolationsfehlers geschlossen wird in dem
b1) der von der Prüfspannung hervorgerufene Strom gemessen und, wenn dessen Betrag einen vorgegebenen Grenzwert überschreitet, auf das Vorliegen eines lsolationsfehlers geschlossen wird **oder**
b2) die sich einstellende Prüfspannung Uₕ gemessen und, wenn diese einen vorgegebenen Grenzwert unter- bzw. überschreitet, auf das Vorliegen eines lsolationsfehlers geschlossen wird; und
c1) falls ein solcher vorliegt, eine Fehlermeldung abgegeben und die niederohmige Stromquelle bzw. -senke nicht mit der Schaltung verbunden wird;
c2) falls ein solcher nicht vorliegt, die niederohmige Stromquelle bzw. -senke mit der Schaltung verbunden wird.

Bei dieser Lösung wird also die aufgetrennte Schaltung bereits durch das Anlegen der Prüfspannung im Schritt a) auf ein Potential gebracht, welches demjenigen entspricht, das bei der späteren Verbindung mit der niederohmigen Stromquelle bzw. -senke (d.h. beim obigen Airbag-Beispiel bei der entsprechenden Schalterprüfung) anliegt. Somit werden die maximalen elektrostatischen Kräfte bereits im Schritt a) wirksam, so daß sich ein verborgener Isolationsfehler bereits hier durch einen eintretenden Kurzschluß zeigt. Da der Strom hier jedoch begrenzt ist, hat dies keine nachteilige Folge, sondern führt nur zu einem Zusammenbrechen der Prüfspannung. Liegt von vornherein ein Kurzschluß vor, kann sich die Prüfspannung aufgrund der Strombegrenzung gar nicht erst aufbauen. Dieses Strom- und/oder Spannungsverhalten dient im folgenden Schritt b) zum Erkennen des Isolationsfehlers.

Das erfindungsgemäße Verfahren hat den Vorteil, daß auch Isolationsfehler, die bei niedrigen Prüfspannungen verborgen blieben, zuverlässig erkannt werden können und dadurch Kurzschlüsse mit nachteilige Folgen, wie z.B. einem Kabelbaumbrand oder einer Airbag-Fehlauslösung, praktisch ausschließbar sind.

Bei vielen Anwendungen sollen neben dem obigen Verfahren noch weitere Prüfungen durchgeführt werden. Es kann hierbei vorteilhaft sein, diese nicht nur vor oder nach Vollendung der Schrittfolge a) bis c1) bzw. c2), sondern in einer mit ihr verschachtelten Weise auszuführen. Zwischen die Schritte b) und c2) und ggf. zwischen b) und c1) können hierzu andere Verfahrensschritte eingeschoben sein. In manchen Fällen, wie im obigen Beispiel einer Airbag-Schalterprüfung, besteht die andere Prüfung in der nochmaligen Durchführung des erfindungsgemäßen Verfahrens, und zwar, nachdem es zunächst für die niederohmige Stromquelle durchgeführt wird, nun für die dazu komplementäre niederohmige Stromsenke - oder umgekehrt (im folgenden wird dies "Komplementärverfahren" genannt). Grundsätzlich kann man hierzu das Verfahren als Ganzes nacheinander für Stromquelle und Stromsenke durchführen. Um die Prüfungsphase (d.h. die Schritte a) und b)) zusammenzufassen, wählt man jedoch vorzugsweise eine verschachtelte Ausführungsart, bei der man nach den Schritten a) und b) z.B. für die niederohmige Stromquelle zunächst die entsprechenden Schritte a) und b) für die komplementäre Stromsenke, und dann erst - falls kein Fehler gefunden wird - die Schritte c2) für die beiden ausführt. Der im Fehlerfall auszuführende Schritt c1) (d.h. die Fehlermeldung) kann alternativ unmittelbar im Anschluß an a) und b) oder auch erst nach den eingeschobenen Schritten des Komplementärverfahrens ausgeführt werden.

Das Schließen auf das Vorliegen eines Isolationsfehlers im Schritt b) kann vorzugsweise erfolgen, indem man den von der Prüfspannung hervorgerufenen Strom mißt und fragt, ob sein Betrag einen vorgegebenen Grenzwert überschreitet. Einfacher und daher besonders bevorzugt ist es jedoch, die sich einstellende (im Kurzschlußfall zusammenbrechende) Prüfspannung Uₕ zu messen, und zu fragen, ob sie einen vorgegebenen Grenzwert unterschreitet bzw. - im Fall einer Stromsenke - überschreitet.

Grundsätzlich kann das Verfahren auf jede Art von Schaltung, bei der sich Isolationsfehler beim Verbinden mit einer niederohmigen Stromquelle bzw. -senke nachteilig auswirken, angewendet werden. Vorteilhaft ist die Schaltung Teil eines eigendiagnosefähigen Sytems, wobei das Verfahren im Rahmen einer Eigendiagnose dieses Systems durchgeführt wird. Vorzugsweise handelt es sich hierbei um eine Auslöseeinrichtung eines Fahrzeugsicherheitssystems, wie zum Beispiel eines Überschlagschutzsystems, Gurtstraffersystems oder Airbag-Systems. Insbesondere bei letzterem bringt eine Fehlauslösung eine beträchtliche Unfallgefahr mit sich, so daß hier das Verfahren, indem es solche Fehlauslösungen praktisch ausschließt, besonders vorteilhaft ist.

Vorzugsweise dient im Rahmen der Eigendiagnose der letzte Verfahrensschritt, bei dem die Schaltung mit der niederohmigen Stromquelle bzw. -senke verbunden wird (Schritt c2), dazu, einen Leistungschalter der Schaltung zu prüfen. Dieser kann z.B. bei einer Auslöseeinrichtung dazu bestimmt sein, den Auslösestrom zu steuern. Die Schalterprüfung kann insbesondere auf der Auswertung des am geschlossenen Leistungsschalter abgegriffenen Stromflusses beruhen.

Zur Strombegrenzung bei der Schalterprüfung verwendet man vorzugsweise als Gegenstück zur niederohmigen Stromquelle bzw. -senke eine strombegrenzte Stromsenke bzw. -quelle. Dieser Art der "komplementären" Strombegrenzung wohnt - wie eingangs bereits erläutert wurde - an sich die Gefahr von Fehlauslösungen durch verborgene Isolationsfehler inne, die jedoch durch die Erfindung ausgeräumt ist.

Besonders einfach und daher bevorzugt ist es, bei der Durchführung von Verfahren und Komplementärverfahren in dem einen Verfahren für die Isolationsprüfung im Schritt a) und in dem dazu komplementären für die Schalterprüfung im Schritt c2) nicht etwa verschiedene, sondern ein- und dieselbe strombegrenzten Stromquelle bzw. -senke zu verwenden.

Im allgemeinen werden bei der Selbstdiagnose eines Sicherheitssystems nicht nur die Leistungsschalter, sondern auch ein von ihnen geschaltetes Auslöseelement, insbesondere ein Airbag-Zündmittel, geprüft. Hierzu kann z.B. die unter einem geringen Prüfstrom (im Nichtauslösebereich) über das Auslöseelement abfallende Spannung ausgewertet werden. Zur potentialfreien Prüfung des Auslöseelements wird der Prüfstrom von einer strombegrenzten Stromquelle und -senke bei geöffneten Leistungsschaltern geliefert. Vorteilhaft werden hierfür die zur Widerstandsmessung im Schritt a) und der Schalterprüfung im Schritt c2) benutzten Stromquellen bzw. Stromsenken verwendet. Der Übergang von einer zur anderen Betriebsart erfolgt auf einfache Weise, indem man sie zur Auslöseelementprüfung gemeinsam, zur Isolationsprüfung hingegen jeweils nur einzeln aktiviert. Bei der Schalterprüfung ist neben einer einzelnen Aktivierung auch eine gemeinsame möglich, da jeweils eine der strombegrenzten Stromquelle und -senke über den geschlossenen Leistungsschalter parallel zur niederohmigen Stromquelle bzw. -senke geschaltet ist und sich daher auch im aktivierten Zustand nicht auswirkt.

Die Erfindung ist auch auf ein System zur Durchführung des obigen Verfahrens gerichtet, mit:
- einer strombegrenzten Stromquelle und/oder -senke, deren Ruhespannung(en) Uₕ₀ mindestens bzw. - im Fall einer Stromsenke - höchstens der Spannung Uₙ₀ entspricht (entsprechen), zum Beaufschlagen der in aufgetrenntem Zustand befindlichen Schaltung mit einer Prüfspannung;
- einem Mittel, das aus dem Strom- und/oder Spannungsverhalten bei der Prüfspannungsbeaufschlagung auf das Vorliegen oder Nichtvorliegen eines Isolationsfehlers schließt, dadurch, dass es zum Schliessen auf einen Isolationsfehler dazu eingerichtet ist,
   **b1)** den von der Prüfspannung hervorgerufenen Strom zu messen, um bei Überschreiten eines vorgegebenen Grenzwerts auf das Vorliegen eines lsolationsfehlers zu schliessen oder
   **b2)** dass es zum Schliessen auf einen Isolationsfehler dazu angepasst ist, die sich bei der Beaufschlagung einstellende Prüfspannung Uₕ zu messen, um bei Unter- bzw. Überschreitung eines vorgegebenen Grenzwerts auf das Vorliegen eines lsolationsfehlers zu schliessen:
- und einem Mittel, das veranlasst, dass bei Vorliegen eines Isolationsfehlers eine Fehlermeldung abgegeben und die niederohmige Stromquelle bzw. -senke nicht mit der Schaltung verbunden wird, und bei Nichtvorliegen diese mit der Schaltung verbunden wird.
Diese Mittel werden vorteilhaft hauptsächlich durch wenigstens einen geeignet programmierten Mikrocomputer gebildet.

Das System bildet vorzugsweise einen Teil eines eigendiagnosefähigen Systems, wobei der Begriff "Teil" auch den Grenzfall einschließt, bei dem das System das gesamte eigendiagnosefähige System ausmacht. Insbesondere handelt es sich hierbei um eine Auslöseeinrichtung eines Fahrzeugsicherheitssystems, z.B. eines Airbag-Systems.

Weitere bevorzugte Ausgestaltungen des Systems sind in den Unteransprüchen 12 bis 15 angegeben. Näheres hierzu findet sich in den obigen Erläuterungen zum Verfahren.

Die Erfindung wird nun anhand von Ausführungsbeispielen und der angefügten schematischen Zeichnung näher erläutert. In der Zeichnung zeigen:
- Fig. 1: ein Blockschema eines Airbag-Systems, das ein System zum Erkennen von Isolationsfehlern beinhaltet; und
- Fig. 2: ein Ablaufschema eines Eigendiagnoseverfahrens eines Airbag-Systems, in dem ein Verfahren zum Erkennen von Isolationsfehlern eingebettet ist.

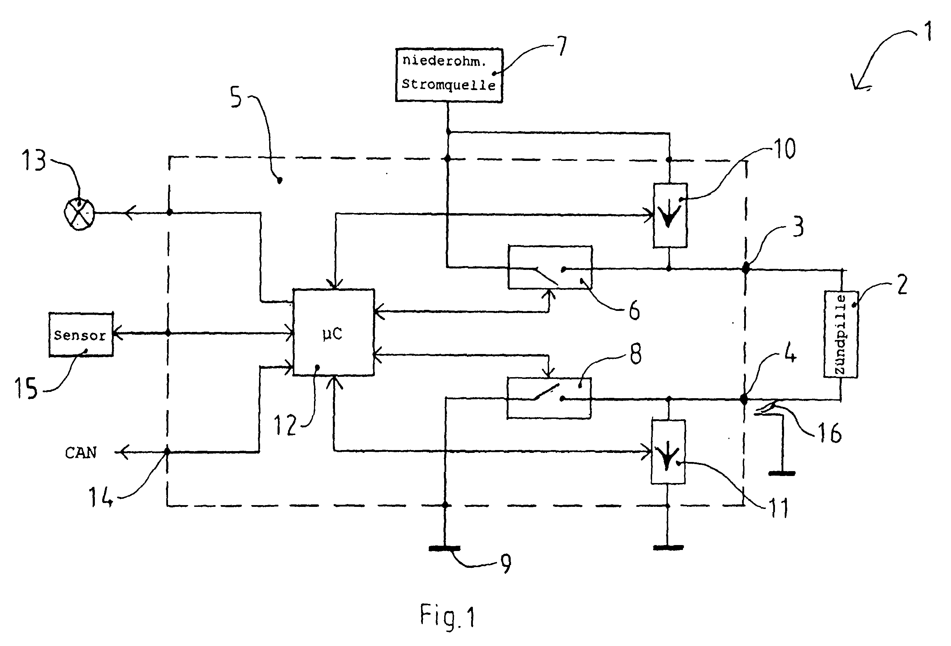

Das Airbag-System 1 gemäß Fig. 1 weist zum Auslösen eines (nicht gezeigten) Airbags ein Zündmittel, hier eine Zündpille 2, auf. Diese ist mit ihren beiden Anschlußleitungen jeweils über eine Steckverbindung 3, 4 mit einer Auslöse- und Prüfschaltung 5 verbunden, und zwar einerseits über einen stromaufwärtigen Leistungsschalter 6 mit einer niederohmigen Stromquelle 7, und andererseits über einen stromabwärtigen Leistungsschalter 8 mit der Masse 9, welche die Funktion einer niederohmigen Stromsenke hat. Bei den Leistungsschaltern 6, 8 handelt es sich um elektronisch steuerbare Schalter, insbesondere Halbleiterschalter, beispielsweise in Form von Endstufenverstärkern. Parallel zum stromaufwärtigen Leistungsschalter 6 ist eine strombegrenzte Stromquelle 10 geschaltet. Komplementär dazu ist parallel zum stromabwärtigen Leistungsschalter 8 eine strombegrenzte Stromsenke 11 geschaltet.

Die niederohmige Stromquelle 7 hat eine Ruhespannung Uₙ₀ bezogen auf die Masse 9, die hier z.B. 30 V beträgt. Die Ruhespannung Uₕ₀ der strombegrenzten Stromquelle 10 gleicht dieser, beträgt hier also ebenfalls 30 V, bezogen auf die Masse 9. Entsprechend gleicht die Ruhespannung Uₕ₀ der strombegrenzten Stromsenke 11 derjenigen der Masse 9, beträgt also 0 V. "Niederohmig" bedeutet hier, daß der bei Verbindung mit der Zündpille 2 von der Stromquelle 7 gelieferte und der Masse 9 aufgenommene Strom groß genug ist, um diese auszulösen. Hingegen ist die Strombegrenzung der Stromquelle 10 und Stromsenke 11 derart, daß der von ihnen bei Verbindung mit der Zündpille 2 gelieferte bzw. aufgenommene Strom diese nicht auslösen kann. Ihr maximaler Strom liegt typischerweise unter 100 mA, insbesondere liegt er zwischen 20 und 40 mA. Damit nur eine von ihnen in definierter Weise für die Strombegrenzung sorgt, können sie einen unterschiedlichen Strom-Grenzwert haben, z.B. die Stromquelle 10 20 mA und die Stromsenke 11 40 mA.

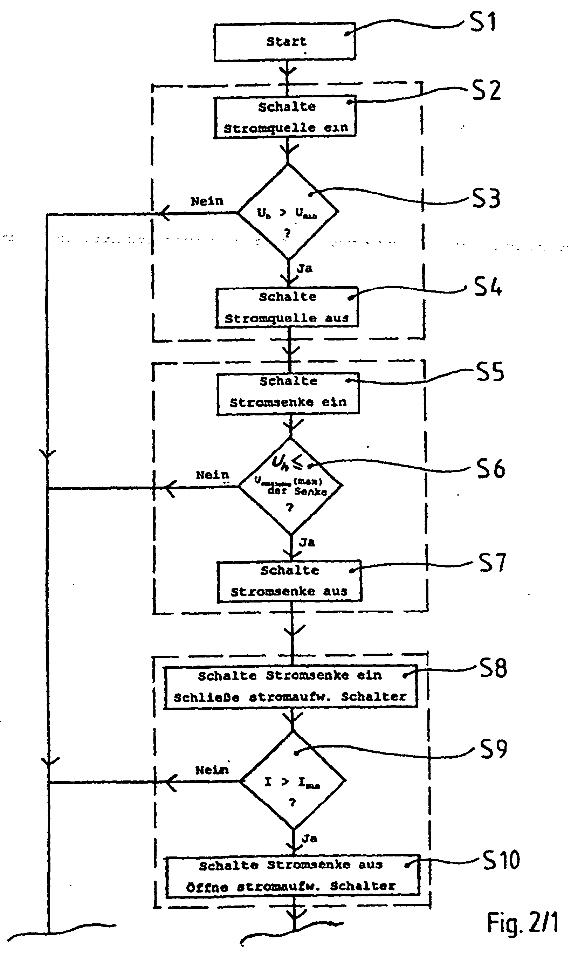

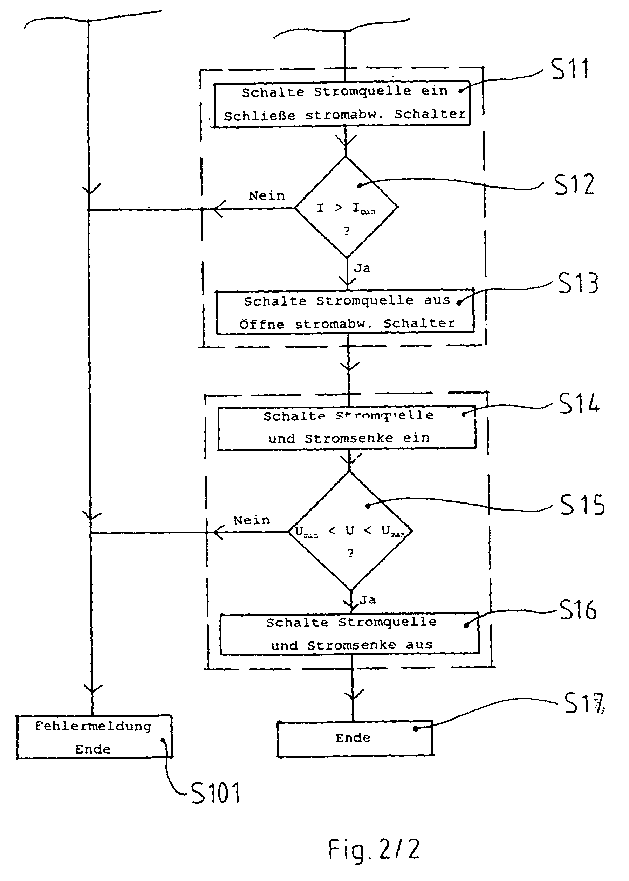

Ein Mikrocomputer 12, beispielsweise gebildet durch einen Mikrocontroller, kann die Leistungsschalter 6, 8 unabhängig voneinander betätigen und die strombegrenzte Stromquelle 10 und Stromsenke 11 unabhängig voneinander ein- und ausschalten. Er kann auch die Information der durch die Leistungsschalter 6, 8 fließenden Ströme, die dort mit Hilfe einer (nicht gezeigten) Strommeßschaltung abgegriffen werden, einlesen. Er kann ferner die vor und hinter der Zündpille 2 anliegende Spannung, die von (nicht gezeigten) Spannungsmeßschaltungen gemessen werden, einlesen. Er kann schließlich eine Fehlermeldeeinrichtung 13, z.B. eine Lampe, ansteuern und mit anderen Fahrzeug- oder Diagnoseeinrichtungen über eine Kommunikationsschnittstelle 14, z.B. über einen CAN-Bus, kommunizieren. Ein Aufprallsensor 15 signalisiert dem Mikrocomputer 12, wann er den Airbag ausgelösen soll. Der Mikrocomputer 12 ist so programmiert, daß er das - weiter unten beschriebene - Eigendiagnoseverfahren gemäß Fig. 2 ausführen kann.

Die Auslöse- und Prüfschaltung 5 kann die folgenden Zustände annehmen: Im Normalzustand sind beide Leistungsschalter 6, 8 geöffnet und die strombegrenzte Stromquelle 10 und Stromsenke 11 ausgeschaltet. Im Auslösefall werden beide Leistungsschalter 6, 8 geschlossen; die Zündpille 2 zündet dann. Für die Eigendiagnose gibt es wenigstens drei verschiedene Betriebsarten. In einer ersten Betriebsart kann die Zündpille 2 geprüft werden, indem bei geöffneten Leistungsschaltern 6, 8 und gemeinsam eingeschalteter strombegrenzter Stromquelle 10 und Stromsenke 11 die Spannung ausgewertet wird, die unter dem dann fließenden begrenzten Prüfstrom über sie abfällt. In einer zweiten Betriebsart wird zur Prüfung der Leistungsschalter 6, 8 bei gemeinsam eingeschalteter strombegrenzter Stromquelle 10 und Stromsenke 11 jeweils nur einer der Schalter 6, 8 geschlossen und der durch ihn fließende Prüfstrom ausgewertet. Bei getrennt eingeschalteter Stromquelle und Stromsenke wird die komplementäre Seite ausgewertet. Wird im ersten Fall der stromaufwärtige Leistungsschalter 6 geschlossen, so fließt ein Prüfstrom von der niederohmigen Stromquelle 7 durch ihn über die Zündpille 2 zur strombegrenzten Stromsenke 11. Da letztere alleine den Strom begrenzt, fällt über sie praktisch die gesamte Spannung ab, so daß der gesamte, vor ihr liegende Zündkreis auf die Ruhespannung Uₙ₀ der niederohmigen Stromquelle 7 gehoben wird. Wird im anderen Fall der stromabwärtige Leistungsschalter 8 geschlossen, so fließt ein Prüfstrom von der strombegrenzten Stromquelle 10 durch die Zündpille 2 und den stromabwärtigen Schalter 8 zur Masse 9. Die Strombegrenzung wird hier allein durch die strombegrenzte Stromquelle 10 vermittelt, so daß der gesamte, ihr folgende Zündkreis praktisch auf Massepotential zu liegen kommt.

Wie eingangs bereits ausgeführt wurde, kann diese Prüfung der Leistungsschalter 6, 8 an sich bei Vorliegen eines Isolationsfehlers zu einer Fehlauslösung des Airbags führen. Zur Veranschaulichung eines verborgenen Isolationsfehlers ist ein metallischer Span 16 im Bereich der stromabwärtigen Steckverbindung 4 dargestellt, der anfangs noch keinen Kontakt zur Masse herstellen soll. Bei einer herkömmlichen Leckschlußprüfung mit niedriger Prüfspannung bliebe er unbemerkt. Wenn dann bei der Prüfung des stromaufwärtigen Leistungsschalters 6 der gesamte Zündkreis auf die relativ hohe Spannung Uₙ₀ gehoben würde, könnte er aufgrund der dann größeren elektrostatischen Kräfte Kontakt zur Masse herstellen, wodurch die strombegrenzende Wirkung der Stromsenke 11 entfiele und die Zündpille 2 gezündet würde. Entsprechendes könnte - wenn auch mit geringerer Wahrscheinlichkeit - bei der Prüfung des stromabwärtigen Leistungsschalters 8 passieren, wenn ein Isolationsfehler im stromaufwärtigen Teil des Kreises einen Schluß zur niederohmigen Stromquelle 7 herstellte.

Um dies auszuschließen, können in einer dritten Diagnose-Betriebsart zur Isolationsprüfung die strombegrenzte Stromquelle 10 und Stromsenke 11 bei geöffneten Leistungsschaltern 6, 8 einzeln ein- und ausgeschaltet werden. Liegt im ersten Fall eingeschalteter strombegrenzter Stromquelle 10 und ausgeschalteter Stromsenke 11 keinerlei Isolationsfehler vor, so fließt wegen der Auftrennung durch die geöffneten Schalter 6, 8 kein Strom im Zündkreis und es stellt sich die hohe Ruhespannung Uₕ₀ ein, die der Spannung Uₙ₀ der niederohmigen Stromquelle 7 entspricht. Bei einem unverborgenen Isolationsfehler, d.h. einem von Anfang an gegebenen Masseschluß, bleibt die Spannung im Zündkreis aufgrund der Strombegrenzung der Stromquelle 10 nahe dem Massepotential. Bei einem verborgenen Isolationsfehler, z.B. dem Span 16, wird der Zündkreis zunächst auf eine relative hohe Spannung in Richtung Ruhespannung Uₙ₀ gehoben. Die damit einhergehenden, größer werdenden elektrostatischen Kräfte verursachen dann einen Masseschluß, woraufhin die Spannung im Zündkreis auf einen Wert nahe dem Massepotential zusammenbricht. Die sich ergebende Spannung im Zündkreis, die z.B. mit den (nicht gezeigten) Spannungsmeßschaltungen an der Zündpille 2 erfaßt werden kann, ist also ein Maß für das Vorliegen oder Nichtvorliegen eines Isolationsfehlers. Bei der Isolationsprüfung selbst ist dabei eine Fehlauslösung des Airbags wegen der Strombegrenzung ausgeschlossen. Entsprechendes gilt für den zweiten Fall, bei dem die strombegrenzte Stromsenke 11 ein- und die Stromquelle 10 ausgeschaltet ist.

Das Diagnoseverfahren gemäß Fig. 2 beginnt im Schritt S1 mit beiden Leistungsschaltern 6, 8 in geöffnetem und der strombegrenzten Stromquelle 10 und Stromsenke 11 in ausgeschaltetem Zustand; die niederohmige Stromquelle 7 ist immer aktiv. (Anmerkung: in Fig. 2 sind mit "Stromquelle" und "Stromsenke" immer die strombegrenzten gemeint.) Zunächst wird in einem ersten Verfahrensabschnitt eine Isolationsprüfung mit hoher strombegrenzter Spannung am Zündkreis durchgeführt. Dazu wird im Schritt S2 die strombegrenzte Stromquelle 10 eingeschaltet. Im folgenden Schritt S3 wird gefragt, ob die sich im Zündkreis einstellende Spannung Uₕ über einer vorgegebenen Mindestspannung Uₘᵢₙ, hier 4,5 V, eingestellt hat. Falls nein, liegt ein Isolationsfehler vor, so daß im Schritt S101 eine Fehlermeldung über die Fehlermeldeeinrichtung 13 gegeben wird und das Verfahren beendet wird. Falls ja, wird der erste Verfahrensabschnitt im Schritt S4 mit dem Ausschalten der strombegrenzten Stromquelle 10 abgeschlossen.

Im einem zweiten Verfahrensabschnitt wird die Isolationsprüfung mit strombegrenzter Spannung auf Massepotential durchgeführt. Dazu wird im Schritt S5 die strombegrenzte Stromsenke 11 eingeschaltet. Im Schritt S6 wird gefragt, ob die sich ergebende Spannung Uₕ im Zündkreis kleiner gleich der maximalen Sättigungsspannung der Senke ist. Falls nein wird im Schritt S101 eine Fehlermeldung abgegeben und das Verfahren beendet. Falls ja liegt kein Isolationsfehler vor; der zweite Verfahrensabschnitt wird dann im Schritt S7 durch Ausschalten der strombegrenzten Stromsenke 11 abgeschlossen.

Im dritten Verfahrensabschnitt zur Prüfung des stromaufwärtigen Leistungsschalters 6 werden im Schritt S8 die strombegrenzte Stromsenke 11 eingeschaltet (alternativ können auch Stromquelle 10 und -senke 11 gemeinsam eingeschaltet werden) und der Schalter 6 geschlossen. Im Schritt S9 wird gefragt, ob der durch ihn fließende Strom größer als ein vorgegebener Mindeststrom Iₘᵢₙ, hier 10 mA, ist. Falls nein wird im Schritt S101 eine Fehlermeldung abgegeben und das Verfahren beendet. Falls ja wird im Schritt S10 der dritte Verfahrensabschnitt durch Ausschalten der Stromsenke 11 und Öffnen des als funktionsfähig anzusehenden stromaufwärtigen Leistungsschalters 6 abgeschlossen.

Im vierten Verfahrenabschnitt zur Prüfung des stromabwärtigen Leistungsschalters 8 wird im Schritt S11 die strombegrenzte Stromquelle 10 eingeschaltet und der Schalter 8 geschlossen. Im Schritt S12 wird gefragt, ob der durch ihn fließende Strom über einem vorgegebenen Mindeststrom Iₘᵢₙ, hier 10 mA liegt. Falls nein, wird im Schritt S101 eine Fehlermeldung abgegeben und das Verfahren beendet. Falls ja wird der vierte Verfahrensabschnitt im Schritt S13 durch Ausschalten der Stromquelle 10 und Öffnen des als funktionsfähig anzusehenden stromabwärtigen Leistungsschalters 8 abgeschlossen.

Im fünften Verfahrensabschnitt wird schließlich noch die Zündpille 2 geprüft. Hierzu werden im Schritt S14 die strombegrenzte Stromquelle 10 und Stromsenke 11 gemeinsam eingeschaltet. Im Schritt S15 wird gefragt, ob die die über der Zündpille 2 abfallende Spannung innerhalb eines vorgegebenen Spannungsbereichs Uₘᵢₙ ... Uₘₐₓ, liegt. Falls nein wird im Schritt S101 eine Fehlermeldung abgegeben und das Verfahren beendet. Falls ja wird die Zündpille 2 als funktionsfähig angesehen; der fünfte Verfahrensabschnitt wird dann im Schritt S16 durch Ausschalten der strombegrenzten Stromquelle 10 und Stromsenke 11 abgeschlossen. Das Diagnoseverfahren endet fehlerfrei im Schritt S17.

Bei anderen (nicht gezeigten) Ausführungsformen werden die Verfahrensabschnitte in anderer Reihenfolge durchgeführt; z.B. der fünfte Abschnitt (Zündpillenprüfung) unmittelbar nach dem Start (Schritt S1). In einem anderen Beispiel wird die Prüfung eines Schalters jeweils unmittelbar nach der entsprechenden Isolationsprüfung durchgeführt, d.h. der dritte Abschnitt unmittelbar nach dem ersten und der vierte unmittelbar nach dem zweiten. Wichtig bei all diesen Varianten ist nur, daß einer Schalterprüfung jeweils die entsprechende Isolationsprüfung vorausgeht, also der erste Abschnitt vor dem dritten und der zweite vor dem vierten kommt.

Um diese Verschiebbarkeit der Verfahrensabschnitte zu veranschaulichen, enthält das in Fig. 2 dargestellte Beispiel im übrigen Verfahrensschritte, die an sich nicht nötig sind (z.B. das Paar S7 und S8) und bei festgelegter Reihenfolge entfallen können.

## Patentansprüche

1. Verfahren zum Erkennen von lsolationsfehlern in einer Schaltung (5), die mit einer niederohmigen Stromquelle oder -senke (7, 9) mit Ruhespannung Uₙ₀ verbunden werden soll, bei welchem
**a)** die Schaltung (5) in nicht verbundenem Zustand mit einer Prüfspannung aus einer strombegrenzten Stromquelle bzw. -senke (10, 11), deren Ruhespannung Uₕ₀ der Spannung Uₙ₀ entspricht oder sie über- bzw. unterschreitet, beaufschlagt wird;
**b)** aus dem Strom- und/oder Spannungs-Verhalten bei der Prüfspannungsbeaufschlagung auf das Vorliegen oder Nichtvorliegen eines lsolationsfehlers geschlossen wird, indem
**b1)** der von der Prüfspannung hervorgerufene Strom gemessen und, wenn dessen Betrag einen vorgegebenen Grenzwert überschreitet (S9, S12), auf das Vorliegen eines lsolationsfehlers geschlossen wird **oder**
**b2)** die sich einstellende Prüfspannung Uₕ gemessen und, wenn diese einen vorgegebenen Grenzwert unter- bzw. überschreitet (S6 bzw. S3), auf das Vorliegen eines lsolationsfehlers geschlossen wird; und
**c1)** falls ein solcher Fehler vorliegt, eine Fehlermeldung abgegeben (S101) wird und die niederohmige Stromquelle bzw. -senke (7, 9) nicht mit der Schaltung verbunden wird;
**c2)** falls ein solchen Fehler nicht vorliegt, die niederohmige Stromquelle oder -senke (7, 9) mit der Schaltung insbesondere für Prüfzwecke verbunden wird.

2. Verfahren nach Anspruch 1, bei welchem zwischen die Schritte b) und c2) und ggf. zwischen b) und c1) andere Verfahrensschritte eingeschoben sind.

3. Verfahren nach Anspruch 1 oder 2, bei welchem die Schaltung (5) Teil eines eigendiagnosefähigen Systems ist, und das Verfahren im Rahmen einer Eigendiagnose dieses Systems durchgeführt wird.

4. Verfahren nach Anspruch 3, bei welchem es sich bei dem eigendiagnosefähigen System um eine Auslöseeinrichtung eines Fahrzeugsicherheitssystems, insbesondere eines Airbag-Systems (1), handelt.

5. Verfahren nach Anspruch 3 oder 4, bei welchem bei der Eigendiagnose im Schritt c2) durch Verbinden mit der niederohmigen Stromquelle oder -senke (7, 9) ein Leistungsschalter (6, 8) der Schaltung geprüft wird, insbesondere indem am geschlossenen Leistungsschalter der Stromfluss abgegriffen und detektiert wird.

6. Verfahren nach Anspruch 5, bei welchem zur Strombegrenzung im Schritt c2) in Serie zur niederohmigen Stromquelle oder -senke (7, 9) eine strombegrenzte Stromsenke bzw. -quelle (10, 11) geschaltet wird.

7. Verfahren nach Anspruch 6, bei welchem die im Schritt a) zur Isolationsprüfung dienende strombegrenzte Stromquelle bzw. -senke (10, 11) auch als zur Leistungsschalterprüfung dienende strombegrenzte Stromquelle bzw. - senke verwendet wird.

8. Verfahren nach Anspruch 7, bei welchem die strombegrenzte Stromquelle (10) und die strombegrenzte Stromsenke (11) verwendet werden, die neben der Isolationsprüfung im Schritt a) und der Schalterprüfung im Schritt c2) zu einer potentialfreien Prüfung eines Auslöseelements, insbesondere eines Airbag-Zündmittels (2), dienen, wobei sie zur Auslöseelementprüfung gemeinsam, zur lsolationsprüfung hingegen einzeln aktiviert werden.

9. System zur Durchführung des Verfahrens nach einem der Ansprüche 1 bis 8, mit
**a)** einer strombegrenzten Stromquelle (10) bzw. -senke (11), deren Ruhespannungen Uₕ₀ mindestens bzw. höchstens der Spannung Uₙ₀ entsprich entsprechen, zum Beaufschlagen der in nicht verbundenem Zustand befindlichen Schaltung (5) mit einer Prüfspannung;
**b)** einem Mittel, das aus dem Strom- und/oder Spannungs-Verhalten bei der Prüfspannungsbeaufschlagung auf das Vorliegen oder Nichtvorliegen eines lsolationsfehlers schliesst, **dadurch**, dass es zum Schliessen auf einen lsolationsfehler dazu eingerichtet ist,
**b1)** den von der Prüfspannung hervorgerufenen Strom zu messen, um bei Überschreiten eines vorgegebenen Grenzwerts auf das Vorliegen eines Isolationsfehlers zu schliessen **oder**
**b2)** dass es zum Schliessen auf einen Isolationsfehler dazu eingerichtet ist, die sich bei der Beaufschlagung einstellende Prüfspannung Uₕ zu messen, um bei Unter- bzw. Überschreitung eines vorgegebenen Grenzwerts auf das Vorliegen eines Isolationsfehlers zu schliessen;
**c)** und einem Mittel, das veranlasst, dass bei Vorliegen eines Isolationsfehlers eine Fehlermeldung abgegeben und eine niederohmige Stromquelle (7) oder - senke (9) nicht mit der Schaltung (5) verbunden wird, und bei Nichtvorliegen diese mit der Schaltung (5) verbunden wird.

10. System nach Anspruch 9, welches Teil eines eigendiagnosefähigen Systems ist.

11. System nach Anspruch 10, bei welchem es sich bei dem eigendiagnosefähigen System um eine Auslöseeinrichtung eines Fahrzeugsicherheitssystems, insbesondere eines Airbag-Systems (1), handelt.

12. System nach Anspruch 10 oder 11, bei welchem die Schaltung einen oder mehrere Leistungsschalter (6, 8) zur niederohmigen Stromquelle (7) oder - senke (9) aufweist und welches so ausgebildet ist, dass es die Leistungsschalter (6, 8) bei der Eigendiagnose prüft, insbesondere durch Abgreifen des Stromflusses am geschlossenen Schalter (6, 8).

13. System nach Anspruch 12, welches zur Strombegrenzung bei der Leistungsschalterprüfung eine strombegrenzte Stromquelle und/oder-senke aufweist, die in Serie zur niederohmigen Stromsenke (9) oder -quelle (7) schaltbar ist/sind.

14. System nach Anspruch 13, bei welchem ein- und dieselbe strombegrenzte Stromquelle (10) bzw. -senke (11) zur Isolationsprüfung und zur Leistungsschalterprüfung dient.

15. System nach Anspruch 14, mit einer strombegrenzten Stromquelle (10) und Stromsenke (11), die einzeln aktivierbar sind und neben der Schafterprüfung, einzeln aktiviert, zur Isotationsprüfung und, gemeinsam aktiviert, zur Prüfung eines Auslöseelements, insbesondere eines Airbag-Zündmittels (2), dienen können.

## Claims

1. A procedure for detecting insulation errors in a circuit (5) which is to be connected to a low impedance current source or current sink (7, 9) with a static voltage Uₙ₀, in which
**a)** the circuit (5) is subjected when in an unconnected state to a test voltage from a current source or current sink with a limited current (10, 11), the static voltage Uₕ₀ of which corresponds to the voltage Uₙ₀, or exceeds or fails to reach it
**b)** a conclusion is reached from the current and/or the voltage behaviour when the test voltage is applied regarding the presence or absence of an insulation error, whereby
**b1)** the current which is produced by the test voltage is measured and if its total value exceeds a specified limit value (S9, S12), a conclusion is reached that an insulation error is present, **or**
**b2)** the test voltage Uₕ which arises is measured, and when this fails to reach or exceeds a specified limit value (S6 or S3), a conclusion is reached that an insulation error is present, and
**c1)** if such an error is present, an error message is released (S101), and the low impedance current source or current sink (7,9) is not connected to the circuit,
**c2)** if such an error is not present, the low impedance current source or current sink (7, 9) is connected to the circuit, in particular for test purposes.

2. A procedure according to claim 1, in which other procedural steps are inserted between steps b) and c2), and if necessary, between b) and c1).

3. A procedure according to one of claims 1 or 2, in which the circuit (5) is part of a system capable of self-diagnosis, and the procedure is conducted within the framework of the self-diagnosis of this system.

4. A procedure according to claim 3, in which the system capable of self-diagnosis is a trigger device for a vehicle safety system, in particular an airbag system (1).

5. A procedure according to claim 3 or 4, in which in step c2) during the self-diagnosis, a power switch (6, 8) of the circuit is tested by connecting it to the low impedance current source or current sink (7, 9), in particular when the current flow on the closed power switch is tapped and detected.

6. A procedure according to claim 5, in which in order to limit the current in step c2) in sequence with the low impedance current source or current sink (7, 9), a current sink or current source with a limited current (10, 11) is connected.

7. A procedure according to claim 6, in which the current source or current sink with a limited current (10, 11) which is used to test the insulation in step a) is also used as a current source or current sink to test the power switch.

8. A procedure according to claim 7, in which the current source with a limited current (10) and the current sink with a limited current (11) are used, which together with the insulation test in step a) and the switch test in step c2) are used to test a trigger element, in particular an airbag firing device (2), under potential-free conditions, whereby they are activated together in order to test the trigger element, yet individually in order to test the insulation.

9. A system to implement the procedure according to one of the above claims 1 to 8, with
**a)** a current source (10) or current sink (11) with a limited current, the static voltage(s) of which Uₕ₀ correspond(s) at least or at most to the voltage Uₙ₀ in order to apply a test voltage to the circuit (5) when it is not in a connected state
**b)** a device which reaches the conclusion, based on the current and/or the voltage behaviour when the test voltage is applied, as to whether an insulation error is present or not present, being adjusted, in order to reach the conclusion that an insulation error is present, in such a way that it
**b1)** measures the current produced by the test voltage in order to conclude that an insulation error is present when a specified limit value is exceeded, **or**
**b2)** is adjusted, in order to reach the conclusion that an insulation error is present, to measure the test voltage Uₕ which arises when applied, in order to reach the conclusion that an insulation error is present when a specified limit value is not reached or is exceeded
**c)** and a device which causes an error message to be issued when an insulation error is present and a low impedance current source (7) or current sink (9) not to be connected to the circuit (5), and when an insulation error is not present, to connect this with the circuit (5).

10. A system according to claim 9, which is part of a system capable of self-diagnosis.

11. A system according to claim 10, in which the system capable of self-diagnosis is a trigger device for a vehicle safety system, in particular an airbag system (1).

12. A system according to one of claims 10 or 11, in which the circuit comprises one or more power switches (6, 8) for the low impedance current source (7) or current sink (9), and which is formed in such a way that it tests the power switches (6, 8) during the self-diagnosis, in particular by tapping the current flow on the closed switch (6, 8).

13. A system according to claim 12, in which the current limitation when testing the power switch comprises a current source and/or a current sink with a limited current which can be switched in series to the low impedance current sink (9) or current source (7).

14. A system according to claim 13, in which the same current source (10) or current sink (11) with a limited current is used to test the insulation, and to test the power switch.

15. A system according to claim 14 with a current source (10) and current sink (11) with a limited current, which can be activated individually and which can be used, alongside the switch test, to test the insulation when activated individually, and to test a trigger element, in particular an airbag firing device (2), when activated together.

## Revendications

1. Procédé pour la reconnaissance de défauts d'isolement dans un circuit (5), qui doit être connecté avec une source à faible résistance ou un collecteur de courant à faible résistance avec une tension de repos Uₙ₀, selon lequel
a) le circuit (5) en état non connecté est alimenté par une tension de contrôle provenant d'une source à courant limité et/ou d'un collecteur à courant limité (10, 11), dont la tension de repos Uₕ₀ correspond à la tension Uₙ₀ ou lui est supérieure ou inférieure ;
b) on pronostique la présence ou l'absence d'un défaut d'isolement selon le comportement du courant et/ou de la tension lors de l'alimentation en tension de contrôle, par cela que
b1) le courant produit par la tension de contrôle étant mesuré, et lorsqu'il dépasse une valeur limite prédéterminée (S9, S12), la présence d'un défaut d'isolement étant pronostiquée ou
b2) la tension de contrôle Uₕ s'établissant étant mesurée et, lorsqu'elle est supérieure ou inférieure à une valeur limite prédéterminée (S6 ou S3), la présence d'un défaut d'isolement étant pronostiquée ; et
c1) si un tel défaut est présent, une alerte d'erreur est délivrée (S101) et la source de courant à faible résistance ou le collecteur de courant à faible résistance (7, 9) ne sont pas connectés avec le circuit ;
c2) si un tel défaut n'est pas présent, la source de courant à faible résistance ou le collecteur de courant à faible résistance (7, 9) sont connectés avec le circuit, en particulier à des fins de contrôle.

2. Procédé selon la revendication 1, selon lequel entre les étapes b) et c2) et le cas échéant entre b) et c1), d'autres étapes de procédé sont insérées.

3. Procédé selon la revendication 1 ou 2, selon lequel le circuit (5) est un élément d'un système capable d'autodiagnostic et le procédé est exécuté dans le cadre d'un autodiagnostic de ce système.

4. Procédé selon la revendication 3, selon lequel il s'agit, relativement au système capable d'autodiagnostic, d'une installation de déclenchement d'un système de sécurité d'un véhicule à moteur, en particulier d'un système d'airbag (1).

5. Procédé selon la revendication 3 ou 4, selon lequel un interrupteur de puissance (6, 8) du circuit est contrôlé lors de l'autodiagnostic au cours de l'étape c2) par la connexion avec la source de courant à faible résistance ou le collecteur de courant à faible résistance (7, 9), en particulier par le fait que le flux de courant est prélevé et détecté à l'interrupteur de puissance fermé.

6. Procédé selon la revendication 5, selon lequel, au cours de l'étape c2), une source à courant limité ou un collecteur à courant limité (10, 11) sont connectés en série à la source de courant à faible résistance ou au collecteur de courant à faible résistance (7, 9) pour la limitation de courant.

7. Procédé selon la revendication 6, selon lequel la source à courant limité ou le collecteur à courant limité (10, 11) servant au contrôle d'isolement au cours de l'étape a) sont aussi employés comme source à courant limité 10 ou collecteur à courant limité 11 pour le contrôle d'interrupteur de puissance.

8. Procédé selon la revendication 7, selon lequel la source à courant limité (10) et le collecteur à courant limité (11) sont utilisés, qui servent au contrôle sans potentiel d'un élément de déclenchement, en particulier d'un inflammateur d'airbag (2), en plus du contrôle d'isolement au cours de l'étape a) et du contrôle d'interrupteur au cours de l'étape c2), étant activés de concert pour le contrôle de l'élément de déclenchement, et au contraire indépendamment l'un de l'autre pour le contrôle d'isolement.

9. Système pour l'exécution du procédé selon l'une des revendications 1 à 8, avec
a) une source à courant limité (10) ou un collecteur à courant limité (11), dont la tension de repos/les tensions de repos Uₕ₀ correspond/correspondent au minimum à la tension Uₙ₀, pour l'alimentation avec une tension de contrôle du circuit (5) se trouvant en état non connecté ;
b) un moyen qui constate la présence ou l'absence d'un défaut d'isolement selon le comportement du courant et/ou de la tension lors de l'alimentation en tension de contrôle, par le fait que, pour pronostiquer un défaut d'isolement, le susdit moyen est conçu
b1) pour mesurer le courant produit par la tension de contrôle, afin de pronostiquer la présence d'un défaut d'isolement lors du dépassement d'une valeur limite prédéterminée ou
b2) par le fait que, pour pronostiquer un défaut d'isolement, le susdit moyen est conçu pour mesurer la tension de contrôle Uₕ s'établissant lors de l'alimentation, afin de constater la présence d'un défaut d'isolement lors du dépassement ;
c) un moyen qui permet que, lors de la présence d'un défaut d'isolement, une alerte d'erreur soit délivrée et qu'une source de courant à faible résistance (7) ou un collecteur de courant à faible résistance (9) ne soient pas connectés avec le circuit (5), et lors de l'absence d'un défaut d'isolement que ces derniers soient connectés avec le circuit (5).

10. Système selon la revendication 9, lequel est un élément d'un système capable d'autodiagnostic.

11. Système selon la revendication 10, selon lequel il s'agit, relativement au système capable d'autodiagnostic, d'une installation de déclenchement d'un système de sécurité d'un véhicule à moteur, en particulier d'un système d'airbag (1).

12. Système selon la revendication 10 ou 11, selon lequel le circuit présente un ou plusieurs interrupteurs de puissance (6, 8) vers la source de courant à faible résistance (7) ou le collecteur de courant à faible résistance (9) et lequel système est formé de sorte qu'il contrôle les interrupteurs de puissance (6, 8) lors de l'autodiagnostic, en particulier par le prélèvement du flux de courant à l'interrupteur fermé (6, 8).

13. Système selon la revendication 12, lequel présente une source à courant limité et/ou un collecteur à courant limité, qui est/sont commutable(s) en série vers la source de courant à faible résistance (9) ou le collecteur de courant à faible résistance (7).

14. Système selon la revendication 13, selon lequel une seule et la même source à courant limité (10) ou un seul et le même collecteur à courant limité (11) servent au contrôle d'isolement et au contrôle d'interrupteur de puissance.

15. Système selon la revendication 14, avec une source à courant limité (10) et un collecteur à courant limité (11), qui sont activables indépendamment l'un de l'autre et qui, en plus du contrôle d'interrupteur, servent au contrôle d'isolement lorsqu'activés isolément et au contrôle de l'élément de déclenchement, en particulier d'un inflammateur d'airbag (2), lorsqu'activés de concert.
